# EUROPEAN PATENT APPLICATION

(11) **EP 1 643 563 A2**
(43) Date of publication of application: **05.04.2006**
(21) Application number: 05255974.7
(22) Date of filing: 26.09.2005
(51) Int. Cl.: H01L 31/0232

(54) **Microlens structure for opto-electric semiconductor device, and method of manufacture**

(30) Priority: 30.09.2004 US 955722
(71) Applicant: STMicroelectronics, Inc., Carrollton, TX 75006-5039 (US)
(72) Inventor: Wang, Fuchao, Plano, TExas 75025 (US); Fang, Ming, Plano, TX 75024 (US)
(74) Representative: Style, Kelda Camilla Karen

(57) **Abstract**

A semiconductor device includes a semiconductor material substrate, an opto-electric component formed on the substrate, and a first transparent layer formed on an upper surface of the substrate over the component, the layer having a planar upper surface with a cavity formed therein. The first transparent layer has a selected thickness and a first index of refraction. The semiconductor device further includes a lens having a second index of refraction, the lens being formed in the cavity and having a planar upper surface. An upper surface of the lens and the upper surface of the transparent layer may be coplanar, or alternatively, they may lie in separate planes. The semiconductor device may also include a second transparent layer formed over the first layer and lens, as a passivation layer. The first transparent layer may be silicon dioxide, while the lens may be a flowable dielectric.

## Description

### BACKGROUND OF THE INVENTION

### Field of the Invention

This disclosure is related to semiconductor photoelectric devices, and in particular to a microlens on a semiconductor substrate for conditioning light in cooperation with a photoelectric device formed on the substrate.

### Description of the Related Art

The use of opto-electric devices in semiconductor technology is widespread, and includes devices that produce light in various wavelengths, such as lasers and light-emitting diodes, as well as devices that respond to exposure to light, such as photodiodes and photoresistors. Operation of many such devices is optimized by the use of a lens over the device to direct, focus, or collimate the light according to the requirements of a particular application. As semiconductor technology has advanced, and as the use of opto-electric devices has broadened into many new fields, the size of such devices has, in many cases, been reduced to a point that the ability to manufacture smaller devices is limited by the current technology with respect to the ability to manufacture and emplace lenses of corresponding dimensions.

According to one known method, for example, in which an opto-electric device is formed on a semiconductor substrate, a lens is formed over the device by placing a minute drop of transparent polymer material over the device. The volume of fluid in the drop, and the viscosity of the fluid is selected such that, due to the fluid's surface tension, it settles into the form of a lens over the device, and is cured in that formation. The index of refraction of the polymer material is selected to provide a desired degree of refraction. However, such a technique is limited by the ability to precisely control the volume of fluid in the drop, as well as controlling the exact position of the drop on the surface of the substrate. In cases where the opto-electric device is measured in microns or nanometers, precise control of parameters such as placement and volume becomes very problematic.

### BRIEF SUMMARY OF THE INVENTION

According to an embodiment of the invention, a semiconductor device is provided, including a semiconductor material substrate having an upper surface, an opto-electric component formed on the substrate, and a first transparent layer formed on the upper surface of the substrate over the component, the layer having a planar upper surface with a cavity formed therein. The first transparent layer has a selected thickness and a first index of refraction. The semiconductor device further includes a lens having a second index of refraction, the lens being formed in the cavity and having a planar upper surface. An upper surface of the lens and the upper surface of the transparent layer may be coplanar, or alternatively, they may lie in separate planes. The semiconductor device may also include a second transparent layer formed over the first layer and lens, as a passivation layer.

According to one embodiment of the invention, the opto-electric component is a photosensitive device such as a photo diode, a photo resistor, or a photo transistor.

According to another embodiment of the invention, the opto-electric component is a photo producing component, such as a light emitting diode or a laser.

According to various embodiments, the first layer may be silicon dioxide, Flowable Dielectric, or some other transparent material.

According to a further embodiment of the invention, a method of manufacture is provided. The method includes the steps of forming an opto-electric component on a semiconductor substrate, forming a first transparent layer over the component on the substrate, planarizing the first transparent layer to a selected thickness, forming a cavity in an upper surface of the first transparent layer, depositing a second transparent layer over the first transparent layer such that the cavity is filled with the material of the second transparent layer, and planarizing the second transparent layer to a selected thickness.

The first transparent layer has a first index of refraction while the second transparent layer has a second index of refraction.

According to an embodiment of the invention, the forming a cavity step includes depositing an etch resist layer over the first transparent layer, defining the etch resist layer, etching a region of the first transparent layer exposed by the defining step, and removing the etch resist layer.

The depositing step of the second transparent layer may be performed using a flowable dielectric material with spin-on techniques similar to spin-on-glass used in VLSI technology.

### BRIEF DESCRIPTION OF THE SEVERAL VIEWS OF THE DRAWING(S)

In the drawings, identical reference numbers identify similar elements. The sizes and relative positions of elements in the drawings are not necessarily drawn to scale.
Figure 1 shows a semiconductor device during a manufacturing process, according to an embodiment of the invention.
Figures 2-8 show the device of Figure 1 at various later steps in the manufacturing process.
Figure 9 illustrates the device of Figures 1-8 in operation, according to an embodiment of the invention.

### DETAILED DESCRIPTION OF THE INVENTION

A method of manufacture of a microlens as part of an optically active device, according to one embodiment of the invention, will be described with reference to the accompanying figures.

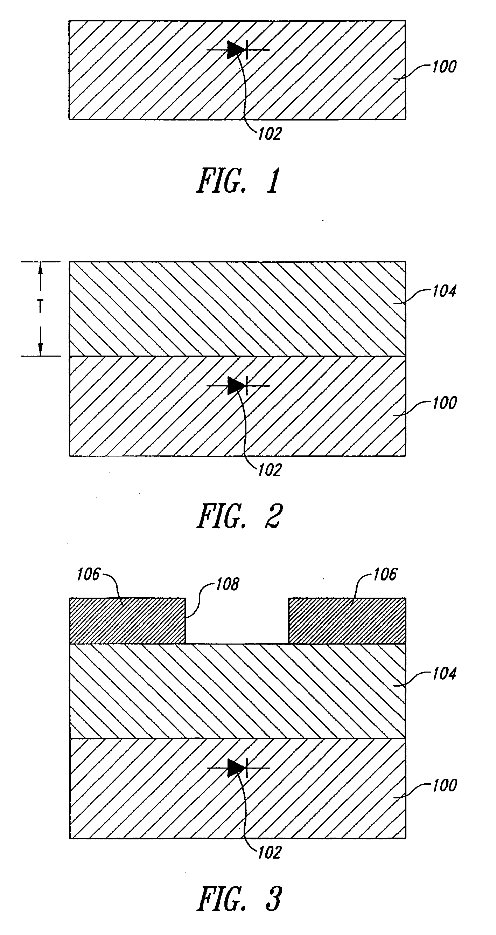

Figure 1 shows a semiconductor substrate 100 on which is formed an opto-electric device 102. The opto-electric device 102 of Figure 1 is depicted as a diode. However, it will be recognized that the device 102 may be any one of a large number of opto-electric devices, including photo-sensitive devices, such as various types of resistors, diodes, or transistors, and also including photo producing devices such as laser diodes and light emitting diodes. Other circuitry and components (not shown) may also be formed on the substrate to produce an integrated microelectronic device that includes the opto-electric device 102.

The semiconductor material substrate may be formed of silicon, GaAs, InP, SiGe, or any other suitable substrate material.

As shown in Figure 2, a transparent dielectric layer 104 such as silicon dioxide (SiO₂) is formed over the substrate 100, and an upper surface thereof is planarized to a selected thickness T. The layer 104 may be deposited by any of several methods, including chemical vapor deposition (CVD), plasma-enhanced chemical vapor deposition (PECVD), and spin-on-glass, and may be planarized by a chemical-mechanical polish (CMP) process. Other processes that provide similar results are also acceptable.

Inasmuch as the layer 104 is formed over a substrate having at least the opto-electric component, and possibly many other integrated components formed thereon, the upper surface of the substrate 100 may be non-planar, due to the nature of semiconductor integrated circuits. For example, the surface may include transistor gates, electrical vias, metallic regions, etched regions, and dielectric regions. Accordingly, a lower surface of the layer 104 will also, in such cases, be correspondingly non-planar as it is formed thereover. Such details are well known in the industry, and so need not be depicted herein.

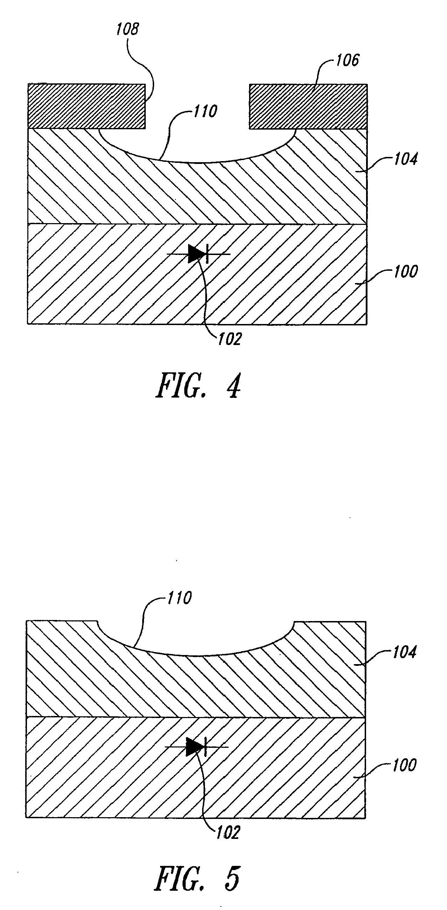

As shown in Figure 3, a photoresist coating 106 is formed over an upper surface of the SiO₂ layer and defined according to known methods, such that an opening 108 of a selected size and shape is formed over the SiO₂ layer and directly above the opto-electric device 102. The SiO₂ layer 104 is then etched through the opening 108 to produce a cavity 110. The etching process may be performed by isotropic or anisotropic method, or by a combination of both. The dimensions of the cavity 110 are selected and controlled by various factors, including the dimensions of the opening 108 and the use of isotropic and anisotropic etching processes. By controlling these factors in combination, the size and shape of the cavity 110 can be closely controlled.

As shown in Figure 5, the photoresist layer 106 is then removed from the surface of the SiO₂ layer 104, leaving the cavity 104 formed in the upper surface of the SiO₂ layer.

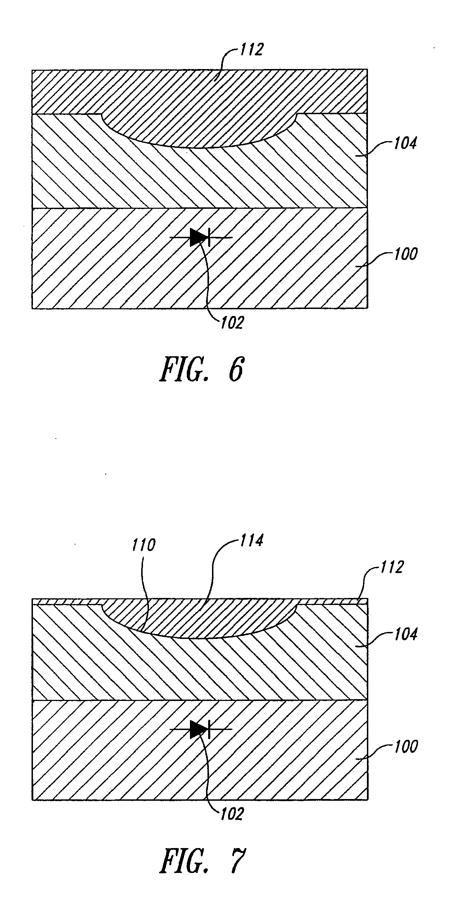

A flowable dielectric (FAD) layer 112 is then formed over the SiO₂ layer 104, as shown in Figure 6, using spin-on techniques. Spin-on techniques are commonly used in semiconductor manufacturing as an intermediate step, for the purpose of providing a planarized surface for further manufacturing. The FAD material has a low viscosity and high wetting characteristics, such that it flows easily into voids and crevices that are formed during many of the manufacturing steps common to microelectronic processes, providing a smooth upper surface for further processing. According to the principles of the present invention, the low viscosity is favorable inasmuch as it ensures that the FAD material will fill the cavity 110 without voids.

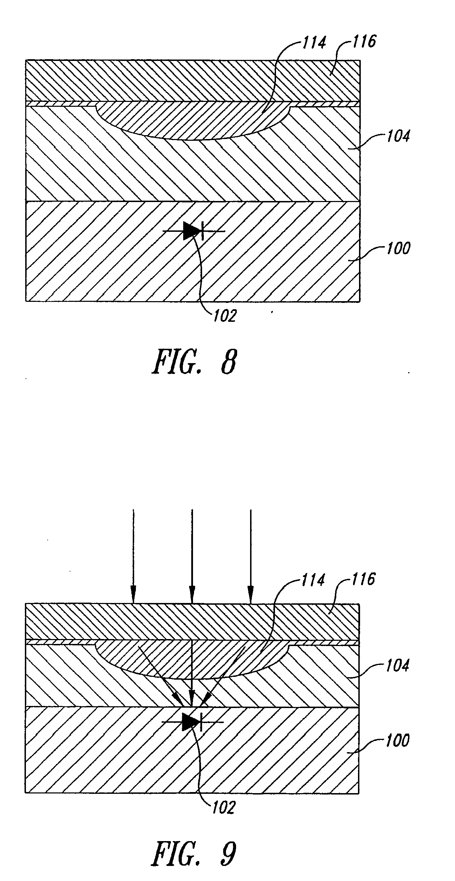

As shown in Figure 7, a CMP process, or the like, is employed to provide an optimally planarized surface on the FAD layer, and to reduce the thickness of the FAD layer to a selected thickness. What remains is a microlens 114 formed in the cavity 110. The thickness of the FAD layer 112 may be reduced to a point that an upper surface of the lens 114 is coplanar with an upper surface of the SiO₂ layer 104, or, as shown in Figure 7, a portion of the FAD layer may be left over the surface of the SiO₂ layer 104. The final thickness of the FAD layer is selected to provide the appropriate focal characteristics to the lens 114. An additional oxide layer may be deposited on the FAD layer before the CMP machining step in order to increase CMP process robustness.

Additionally, the formulation of the FAD layer is selected to result in a microlens having a desired index of refraction. The index of refraction of the microlens 114, in combination with an index of refraction of the SiO₂ layer 104 is selected to provide an appropriate degree of refraction of light entering the lens 114.

In a further step, as pictured in Figure 8, an additional transparent layer 116, such as a passivation layer of oxynitrite may be deposited over the lens 114 for protection of the lens 114, or for further modification of light as it passes therethrough. In the event that the FAD layer 112 has been reduced to coplanarity with the SiO₂ layer 104, the transparent layer 116 will be in contact with the lens 114 at the location of the cavity, and with the SiO₂ layer 104 in a region surrounding the cavity, as far as both layers 104, 116 may coextend.

The process described above may be adapted to produce a plurality of optically active devices on the substrate. The substrate may be cut into dice, each including one or more of the optically active devices, which may then be processed according to known methods for finishing.

According to the embodiment described hereabove, the shape of the lens 114, together with the refractive indices of the SiO₂ layer 104, the lens 114, and the passivation layer 116, are selected such that light entering an upper surface of the device is focused onto the opto-electric device 102, as illustrated in Figure 9.

According to an embodiment of the invention, the refractive index of the FAD layer is selected to be as high as possible, relative to that of the underlying dielectric layer 104, to minimize the necessary thickness of the lens 114. According to other embodiments, the refractive indices of the various layers may be modified according to requirements of the particular embodiment. For example, in some cases it may even be desirable to reverse the relationship, such that the refractive index of the layer 104 may be higher than that of the lens 114.

According to an embodiment of the invention, layer 104 and layer 112 may both be flowable dielectric layers having different formulations such that the respective indices of refraction differ according to a selected value.

It will be observed that the thickness T of the layer 104 is instrumental in controlling the focal point of the lens. Accordingly, layer 104 is planarized to a thickness T that will result, when the microlens is complete, in focusing light entering the lens onto the opto-electric device.

The embodiments described with reference to the accompanying figures depict a microlens positioned over a single opto-electric device. According to another embodiment, the microlens is sized and configured to focus incoming light onto a plurality of opto-electric devices grouped together on the substrate.

According to another embodiment of the invention, the opto-electric device is a light emitting device, such as an LED. The corresponding microlens may be configured to focus light produced by the LED at a selected distance above the upper surface of the lens. The lens may alternatively be configured to collimate the light, or to disperse light. The micro lens may be configured to provide a selected angle of dispersion, as necessary for a particular application or embodiment.

According to an embodiment of the invention, various ones of the lens 114 or other transparent layers, such as the SiO₂ layer 104 or passivation layer 116 may be made opaque to selected wavelengths of light, while transparent to other wavelengths. In this way, the device 102 may be protected from undesirable photo-radiation, while receptive to specific, selected wavelengths. Alternatively, in a case in which the device 102 is a photo-productive device, such as an LED, the light emitted may be filtered to a specific desired wavelength.

It will be recognized that all the steps, processes, and materials described above are commonly used in the semiconductor manufacturing industry. This affords a significant advantage over previously known microlenses. According to known devices, microlenses are either preformed, then mechanically affixed to the surface of a substrate, or are formed over a semiconductor substrate using mechanical devices to position the lens material. In either case, the tolerances achievable in controlling the placement of such lenses is in the micron range and is limited by difficulties in precise control of positioning equipment and other factors. In contrast, the tolerances possible using the present method can be at least one, and perhaps two orders of magnitude tighter. Accordingly, the ability to accurately form and place a microlens over an optically active component is no longer a significant limiting factor in the miniaturization of such components.

Additionally, even when manufacturing microlenses of sizes that are within the ability of current technologies to produce, the methods of the present disclosure have the advantage that they are common to the semiconductor manufacturing industry, and are subject, in most cases, to decades of improvement and development. In contrast, many of the known methods of manufacturing microlenses are recent innovations, and are still subject to the kinds of difficulties and shortcomings that are common to new technologies, resulting in higher rates of rejection and failure.

The steps described above also include sub-steps that are not described in detail, inasmuch as they are well known in the industry. For example, some of the steps may include a baking process, of a particular temperature for a particular duration, to cure or otherwise modify a portion of the device. One having ordinary skill in the art will recognize the sub-steps of the process described, and will be fully capable of determining the specific parameters of those sub-steps without undue experimentation.

Copending application, attorney docket 850063.605, describes further uses of a microlens such as that described above.

All of the above U.S. patents, U.S. patent application publications, U.S. patent applications, foreign patents, foreign patent applications and non-patent publications referred to in this specification and/or listed in the Application Data Sheet, are incorporated herein by reference, in their entirety.

From the foregoing it will be appreciated that, although specific embodiments of the invention have been described herein for purposes of illustration, various modifications may be made without deviating from the spirit and scope of the invention. Accordingly, the invention is not limited except as by the appended claims.

## Claims

1. A semiconductor device, comprising:
a semiconductor material substrate having an upper surface;
a first transparent layer of a selected thickness and having a first index of refraction, formed on the upper surface of the substrate over the component, the layer having a planar upper surface and a cavity formed in the planar upper surface of the first transparent layer; and
a lens having a second index of refraction formed in the cavity and having a planar upper surface.

2. The device of claim1, further comprising an opto-electric component formed on the substrate.

3. The device of claim1 or 2 wherein the upper surface of the lens and the upper surface of the transparent layer are coplanar.

4. The device of claim 1, 2 or 3, further comprising a second transparent layer formed over the first layer and lens.

5. The device of any preceding claim, wherein said device comprises an optoelectric component, the opto-electric component being one of a photodiode, an electrical component whose operating characteristics vary in response to exposure to light, a photoresistor, an electrical component configured to emit light, is an electrical component configured to emit laser radiation, and is a light emitting diode.

6. The device of any preceding claim wherein the first transparent layer is silicon dioxide or a flowable dielectric.

7. The device of any preceding claim wherein the lens is a flowable dielectric.

8. The device of any preceding claim wherein a lower surface of the first transparent layer is non-planar.

9. The device of any preceding claim wherein one of first index of refraction and the second index of refraction is greater than the other of the first index of refraction and the second index of refraction.

10. An opto-electric device, comprising:
a semiconductor substrate;
an optically active component formed on the substrate;
a first layer of material, transparent to a selected wavelength of light and having a first index of refraction, formed on the upper surface of the substrate, the first layer having a planar upper surface;
a cavity formed in the upper surface of the first layer over the component; and
a lens formed in the cavity, the lens having a planar upper surface parallel to the upper surface of the first layer.

11. The opto-electric device of claim 10, further comprising a second layer of material transparent to the selected wavelength of light formed on the upper surface of the lens.

12. The opto-electric device of claim 10 or 11 wherein a region of a lower surface of the second layer of material is in contact with a region of the upper surface of the first layer.

13. A photo-reactive device, comprising:
an integrated component formed on a semiconductor substrate; and
means for focusing light on the integrated component.

14. A method of manufacture, comprising:
forming an opto-electric component on a semiconductor substrate;
forming a transparent layer over the component on the substrate, the transparent layer having a selected index of refraction;
planarizing the transparent layer to a selected thickness;
forming a cavity in an upper surface of the transparent layer;
depositing a transparent material over the transparent layer such that the cavity is filled with the transparent material, the transparent material having a second index of refraction; and
planarizing the transparent material to a selected thickness.

15. The method of claim 14 wherein the forming a cavity step comprises:
depositing an etch resist layer over the transparent layer;
defining the etch resist layer;
etching a region of the transparent layer exposed by the defining step; and
removing the etch resist layer.

16. The method of claim 14 or 15 wherein the depositing step is performed using a spin-on process, and wherein the transparent material is a flowable dielectric.

17. The method of any of claims 14 to 16, further comprising depositing an additional transparent layer over the transparent material.

18. The method of any of claims 14 to 17, further comprising forming an integrated circuit on the semiconductor substrate, the integrated circuit being coupled to the opto-electric component.

19. A method, comprising:
exposing a semiconductor device to a light source; and
focusing light from the light source through a microlens deposited in a cavity formed in a transparent layer of the semiconductor device, such that the light impinges on a photosensitive component integrated onto the semiconductor device.

20. A method, comprising:
generating light in a device formed on a semiconductor substrate;
transmitting the light away from the device; and
modifying transmission properties of the light using a microlens deposited in a cavity formed in a transparent layer of the semiconductor substrate.

21. The method of claim 20 wherein the generating light step is performed using a light emitting diode or a laser.
